# EUROPÄISCHE PATENTSCHRIFT

(11) **EP 3 314 274 B1**
(45) Veröffentlichungstag und Bekanntmachung des Hinweises auf die Patenterteilung: **27.07.2022**
(21) Anmeldenummer: 16766214.7
(22) Anmeldetag: 28.06.2016
(51) Int. Cl.: G01R 15/18

(54) **SCHALTUNGSANORDNUNG ZUR ERFASSUNG VON MINDESTENS ZWEI STROMANSTIEGEN**
CIRCUIT ARRANGEMENT FOR THE DETECTION OF AT LEAST TWO CURRENT RISES
ENSEMBLE DE CIRCUIT POUR DÉTECTER AU MOINS DEUX AUGMENTATIONS DE COURANT

(30) Priorität: 29.06.2015 AT 4152015
(43) Veröffentlichungstag der Anmeldung: 02.05.2018
(73) Patentinhaber: Schrödl, Manfred, 7223 Sieggraben (AT)
(72) Erfinder: Schrödl, Manfred, 7223 Sieggraben (AT)
(74) Vertreter: Graschitz, Roland
(86) Internationale Anmeldenummer: PCT/AT2016/000071
(87) Internationale Veröffentlichungsnummer: WO 2017/000001

(56) Entgegenhaltungen:
- GB-A- 2 501 693
- US-A1- 2012 074 929
- US-A1- 2013 057 267

## Beschreibung

Die Erfindung betrifft eine Schaltungsanordnung zur Erfassung von mindestens zwei Stromanstiegen in mindestens zwei auf einer Leiterplatte angeordneten Leiter.

In elektrischen Kreisen, vorzugsweise in elektrischen Antriebssystemen und Leistungselektronik-Systemen werden häufig elektrische Ströme und gegebenenfalls auch Stromanstiege zur Regelung elektromagnetischer bzw. elektromechanischer Zustände erfasst. Dabei werden elektrische Stromverläufe, also Ströme und/oder deren zeitliche, vorzugsweise erste, Ableitungen, über Sensoren in informationstechnisch einfach verarbeitbare Signale, vorzugsweise Spannungen, umgewandelt. Als bewährte Beispiele solcher Sensoren seien nachstehende Lösungen aufgezeigt:
Messung von Strömen über ohm'sche Shunts:
   Dabei wird der zu messende Strom über einen möglichst ideal linearen ohm'schen Widerstand geführt, an dem der zu messende Strom einen Spannungsabfall hervorruft, der dann streng proportional zum zu messenden Strom ist. Der Widerstandswert ist dabei als Kompromiss zwischen Messsignalamplitude und
   Verlustleistung zu wählen. Speziell ausgeführte niederinduktive Widerstände mit 4 Anschlüssen, davon zwei Messanschlüsse sowie außerhalb davon liegende zwei Energieanschlüsse, sind in Literatur und Anwendung bekannt (Isabellenhütte). Der Nachteil von ohm'schen Shunts zur Strommessung ist eine potenzialbehaftete Erfassung der Messgröße und ein kleines Nutzsignal, wodurch entsprechende Verstärkerschaltungen nachgeschaltet werden müssen.
Messung von Strömen über Transfo-Shunts:
   Den Nachteil der potenzialbehafteten Stromerfassung über ohm'sche Shunts vermeiden so genannte Transfo-Shunts (LEM), die den Strom über das Magnetfeld, das einen stromführenden Leiter umgibt, erfassen. Dabei wird um den Strom führenden Leiter ein magnetisch gut leitender Ring vorgesehen, dessen zum zu messenden Strom proportionales Magnetfeld über ein magnetfeldempfindliches Bauelement, wie etwa eine Feldplatte oder ein Hall-Element, erfasst wird. Zu diesem Zweck wird der magnetisch leitfähige Ring mit einem Spalt ausgeführt, in dem das magnetfeldempfindliche Bauelement angeordnet ist und an dessen Klemme ein monoton mit dem Magnetfeld zusammenhängender Spannungswert erzeugt wird. Dieser Wert kann nun entweder direkt ("nicht kompensierender Wandler" /Honeywell/) oder indirekt ausgewertet werden. Bei der indirekten Methode wird nun mittels einer,
   vorzugsweise mit hoher Windungszahl ausgeführten, Sekundärspule die Durchflutung entgegen der vom zu messenden Strom hervorgerufenen Durchflutung eingeprägt und diese mit einem Regelkreis so geregelt, dass nun im magnetisch leitfähigen Ring die Flussdichte Null auftritt. Dann ist der Strom der Sekundärspule über die Windungszahlenverhältnisse von ursprünglicher Windungszahl der zu messenden Spule zur Sekundärspule proportional und wird über einen nachfolgenden Messverstärker in eine stromproportionale Messgröße umgewandelt. Häufig wird die Spule mit der Windungszahl 1 ausgeführt, also beispielsweise nur durch den magnetisch leitfähigen Ring gesteckt. Diese gesamte genannte Anordnung ist in dem Bauelement "Transfo-Shunt" integriert, wodurch dieses Strommessverfahren sehr teuer ist.
Stromanstiegsmessung über Rogowski-Spulen:
   Dabei wird die magnetische Feldänderung in einer toroidförmigen Luftspule erfasst und die dadurch induzierte Spannung der Toroidspule gemessen, die proportional zur Stromänderung des umschlossenen Leiters ist. Damit ist eine komplizierte geometrische Anordnung zur Erfassung des Stromanstiegs nötig.

Grundsätzlich kann Stromanstiegsinformation für regelungstechnische Aufgaben in verschiedener Weise genützt werden: Beispielsweise kann durch Erfassen von Stromanstiegen in Verbindung mit weiteren elektrischen Messungen, beispielsweise Spannungsmessungen und Strommessungen, am beteiligten elektromagnetischen, beispielsweise eines elektromagnetischen Netzwerkes, oder elektromechanischen System, beispielsweise einer elektrischen Maschine, unter Verwendung der Netzwerk- oder Systemparameter, wie Widerstände, Induktivitäten, Kapazitäten, Spannungsquellen etc., System- und Eingangsgrößen über die entsprechenden Differenzial-Gleichungen berechnet werden. Damit kann man beispielsweise den Strom, dessen Anstieg gemessen wurde, indirekt erfassen. Falls die Messungen redundant sind, also mehr Größen erfasst werden als zu einer eindeutigen Bestimmung nötig sind, können damit Messgrößen oder Parameter verifiziert bzw. redundant und gegebenenfalls unabhängig erfasst werden und damit eine erhöhte Sicherheitsstufe realisiert werden. Weiters kann eine Stromanstiegsmessung direkt etwa zur Induktivitätsbestimmung einer Schaltung oder zur magnetischen Sättigungsauswertung, etwa im Zuge des INFORM^{®}-Verfahrens zur indirekten Rotorflusspositionsbestimmung an elektrischen Maschinen herangezogen werden. Diese Verfahren sind in der EP 1 051 801, der EP 1 746 718 und der EP 2 026 461 beschrieben. Weiterhin sind in US 2012/074929 A1, US 2013/057267 A1 und GB 2 501 693 A Stromsensoren, mit auf Leiterplatten gedruckten Spulen offenbart.

Die zum Stand der Technik aufgezeigten Schaltungsanordnungen zur Strommessung bzw. zur Stromanstiegsmessung haben den Nachteil, dass sie entweder sehr aufwändig oder ungenau sind.

Die Aufgabe der Erfindung ist es, eine Schaltungsanordnung für elektronische Schaltungen auf Leiterplatten, die beispielsweise aus FR4-Werkstoffen, Keramikträgern oder flexiblen Folien etc. hergestellt sind, zu schaffen, die einerseits die obigen Nachteile vermeidet und die anderseits wirtschaftlich sind und qualitativ hochwertige Signale liefern.

Die Aufgabe wird durch die Erfindung gemäß den Ansprüchen 1 und 5 gelöst.

Die erfindungsgemäße Schaltungsanordnung offenbart, dass ein einfacher magnetischer Kreis, unter Verwendung von magnetisch leitfähigen, vorzugsweise geometrisch einfach geformten, Elementen, vorgesehen ist, der die zu messenden elektrischen geprinteten Leiter einschließt, wobei der magnetische Kreis die Leiterplatte als Spalt nutzt und dass mindestens drei, aus mindestens einem Layer, geprintet ausgeführte, Messspulen im Bereich des magnetischen Kreises angeordnet sind, wobei die Messspulen die Flussanstiege der zu messenden Stromanstiege in den geprinteten Leitern als Spulenspannungen erfassen und dass eine messtechnische Auswerteschaltung vorgesehen ist, die mit den Messspulen verbunden ist. Mit der Erfindung ist es erstmals möglich, durch einfache und kostengünstige magnetisch leitfähige Elemente unter Verwendung der Leiterplatte einen einfachen magnetischen Kreis zu schaffen, wobei die Leiterplatte die Funktion eines definierten Spaltes im magnetischen Kreis darstellt. Dabei werden, wie bisher, die elektronischen Schaltungen auf Leiterplatten, wie oben beschrieben, aufgebaut und die zu messenden Ströme über Leiterbahnen aus elektrisch gut, aber magnetisch schlecht leitendem Material geführt. Dieser Faktor der Wirtschaftlichkeit bleibt somit erhalten.

Durch die Realisierung der Spule im Spalt, der der Leiterplatte werden die Spulen vom, durch den Strom bzw. durch das Stromsystem hervorgerufenen, Magnetfeld durchsetzt. Damit ist die Klemmenspannung dieser Spulen in einfachem Zusammenhang mit den Stromanstiegen der beteiligten Leiter. An diese Spulen kann in einfacher Weise eine Signalaufbereitung, beispielsweise über eine Verstärkerschaltung, angeschlossen sein. Somit ist ein weiterer Vorteil der Erfindung darin zu sehen, dass keine komplizierte Auswerte-Hardware und teure Messverstärker benötigt werden und durch entsprechend hohe Windungszahlen der vorzugsweise geprinteten Spulen exakte Messsignale gegeben sind.

Gemäß einem besonderen Merkmal der Erfindung weisen die magnetisch leitfähigen Elemente beispielsweise die Form dünner Quader auf, die an der Ober- und Unterseite der Leiterplatte, vorzugsweise senkrecht auf die zu messenden stromführenden Leiter, angeordnet sind und die, feste oder flexible, Leiterplatte bildet den definierten Spalt im magnetischen Kreis und im bzw. am Spalt sind mindestens drei Messspulen, realisiert auf mindestens einem Layer der Leiterplatte, vorgesehen. Mit einer derartigen Ausbildung verbinden sich im Zuge der Erfindung tadellose Qualität mit hoher Zuverlässigkeit, Raffinesse mit absoluter Perfektion und konsequente Funktionalität mit Innovation.

Nach einem weiteren ganz besonderen Merkmal der Erfindung ist der einfache magnetische Kreis bei einem dreisträngigen Stromsystem aus magnetisch leitfähigen Elementen gemeinsam mit dem Spalt der Leiterplatte und den zu messenden stromführenden Leitern gebildet, der in den Messspulen bei Stromänderungen Spannungen erzeugt, wobei die Spannungen in der Auswerteschaltung zur Bestimmung der Stromanstiege in den stromführenden Leitern heranziehbar sind. Es ist möglich, n+1 Spulen bei n im magnetischen Kreis beteiligten Leitern auszuführen. Dadurch besteht die Möglichkeit, nicht nur alle beteiligten Stromanstiege zu erfassen, sondern auch noch ein allfälliges externes, den Magnetkreis durchsetzendes, Fremdfeld zu berechnen oder zu kompensieren. Gemäß einer Weiterbildung der Erfindung ist im Bereich des Magnetfeldes des einfachen magnetischen Kreises mindestens ein magnetfeldsensitives Bauelement, vorzugsweise als Hall-Element realisiert, vorgesehen, das eine stromproportionale Größe als Ausgangsgröße der Auswerteschaltung zur Verfügung stellt. Damit steht neben dem Stromanstieg auch ein qualitativ hochwertiges direktes stromproportionales Signal zur Verfügung.

Es ist jedoch auch Aufgabe der Erfindung ein Verfahren zur Erfassung von mindestens zwei Stromanstiege in mindestens zwei auf einer Leiterplatte angeordneten Leitern, basierend auf der oben beschriebenen Schaltungsanordnung, zu schaffen.

Auch diese Aufgabe wird durch die Erfindung gelöst.

Das erfindungsgemäße Verfahren ist dadurch gekennzeichnet, dass der einfache magnetische Kreis bei Stromänderungen in einem Leiter Spannungen in den Messspulen erzeugt, die in einer Auswerteschaltung zur Bestimmung der Stromanstiege in den stromführenden Leitern verwendet werden. Dadurch kann der Stromanstieg eines Einzelleiters in einfacher und genauer Weise erfasst werden.

Natürlich können die Stromanstiege eines mehrsträngigen, insbesondere dreisträngigen, Stromsystems erfasst werden. Mit diesem Verfahren kann der Stromanstieg in einem Dreileiter-Drehstromsystem wirtschaftlich erfasst werden.

Gemäß einer Weiterbildung der Erfindung wird der Stromanstieg unter Verwendung der mathematischen Beschreibung des angeschlossenen elektromagnetischen Systems zur Bestimmung des Stromes verwendet.

Nach einer Ausgestaltung der Erfindung wird neben mindestens einer Messung des Stromanstiegs mindestens eine weitere elektrische Größe, vorzugsweise mindestens eine Spannung des Systems "Umrichter - elektromagnetischer Wandler", erfasst.

Gemäß einer besonderen Weiterbildung der Erfindung werden bei der Auswertung der Messspulen die magnetischen Fremdfelder in der Auswertung auf mathematischem Wege eliminiert.

Nach einer weiteren besonderen Ausgestaltung der Erfindung werden die über die Messspulen erfassten Stromanstiege zusätzlich zu Strommessungen zwecks Erfassung einer von den Strommessungen unabhängigen zweiten Informationsquelle über den aktuellen Stromzustand im Sinne einer Strommessungsüberwachung verwendet.

Gemäß einem besonderen Merkmal der Erfindung werden die ermittelten Stromanstiege für ein Verfahren zur sensorlosen Drehwinkelerfassung einer über einen Stromrichter gespeisten synchron mit dem Drehfeld laufenden Maschine (gemäß dem INFORM^{®}-Verfahren) zur Bestimmung der Rotor- bzw. Rotorflussposition von Drehstrommaschinen herangezogen.

Nach einem weiteren besonderen Merkmal der Erfindung werden die ermittelten Stromanstiege gemäß dem auf Magnetlager angepassten Verfahren zur sensorlosen Drehwinkelerfassung einer über einen Stromrichter gespeisten synchron mit dem Drehfeld laufenden Maschine (lNFORM^{®}-Verfahren) zur Bestimmung von Positionsabweichungen des bewegten Teiles eines Magnetlagers gegenüber Referenzpositionen, vorzugsweise in mindestens 2 Raumrichtungen, herangezogen.

Gemäß einer Weiterbildung der Erfindung wird durch Parallel- bzw. Antiparallelführung mindestens zweier stromführender Leiterbahnen innerhalb des einfachen magnetischen Kreises eine magnetische Addition bzw. Subtraktion der eingeschlossenen Durchflutungen durchgeführt und dadurch wird in den Messspulen aufgrund der Summation bzw. Subtraktion der entsprechenden Teilfelder eine direkte Summation bzw. Subtraktion der beteiligten Stromanstiege erreicht.

Nach einem weiteren besonderen Merkmal der Erfindung liefern die Messspulen ein Signal zur Fehlerstromüberwachung, vorzugsweise Erdschlussüberwachung.

Gemäß einer besonderen Weiterbildung der Erfindung werden die zur Bestimmung der Stromanstiege in den stromführenden Leitern verwendeten Spannungen in weiterer Folge in der übergeordneten Steuerung zu höheren Aufgaben, wie etwa Positionsbestimmung, Strom- und Drehzahlregelung und ähnliche herangezogen, wobei optionale weitere Messungen, wie etwa Spannungsmessungen zur genaueren Bestimmung des Zustandes des elektromagnetischen Systems, vorzugsweise einer elektrischen Maschine, der Auswerteschaltung zugeführt werden.

Nach einem weiteren besonderen Merkmal der Erfindung sind die zwei Strom führenden Leiter des Zwischenkreises, der durch die Zwischenkreiskapazität gestützt wird, innerhalb des einfachen magnetischen Kreises im Spalt mit den Messspulen derart geführt, dass die beiden Durchflutungen subtrahiert werden und somit in den Messspulen zwei gegengleiche Spannungen induziert werden, die sich nur durch allfällige externe Störfeldänderungen unterscheiden, welche bei Differenzbildung der Spannungen der Messspulen störfeldbefreit sind und daher die Differenz im Regulärbetrieb ΔU = 0 Volt ist und dadurch bei merkbarer Abweichung der Spannung ΔU von Null eine Fehlerstrom- bzw. Erdschlusserkennung realisiert wird.

Die Erfindung wird an Hand von Ausführungsbeispielen, die in den Zeichnungen dargestellt sind, näher erläutert.

Es zeigen:
Fig. 1 eine Prinzipskizze für eine Erfassung eines Stromanstieges in einem dreisträngigen Stromsystem und
Fig. 2 eine Draufsicht auf den Schnitt A-A in Fig. 1 sowie
Fig. 3 eine Prinzipskizze für die Erfassung eines Stromanstieges von zwei Strom führenden Leitern eines Zwischenkreises und
Fig. 4 eine Draufsicht auf die Fig. 3.

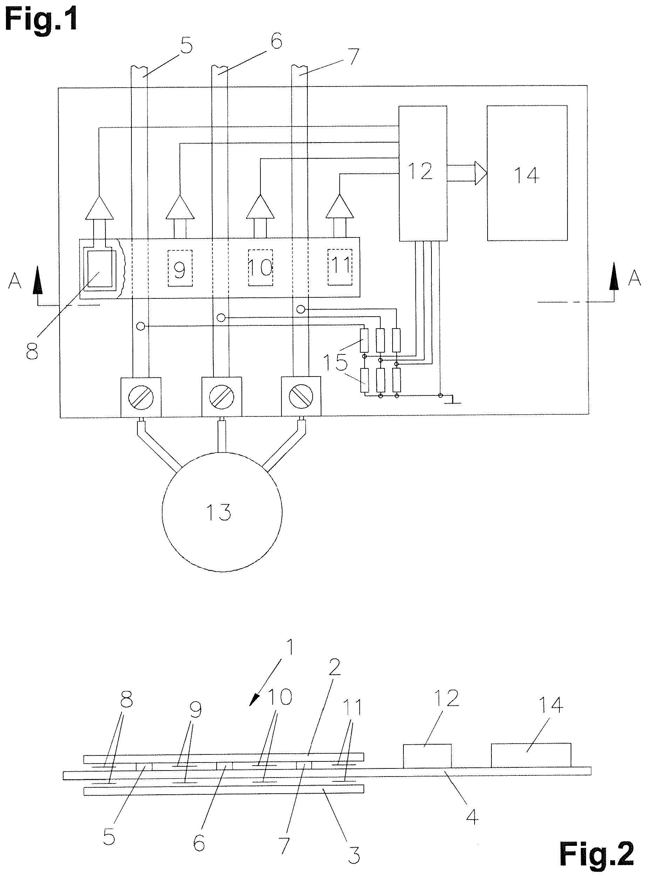

Gemäß der Fig. 1 und 2 ist der einfache magnetische Kreis 1 bei einem dreisträngigen Stromsystem aus magnetisch leitfähigen Elementen 2, 3 gemeinsam mit dem Spalt 4, der Leiterplatte, und den zu messenden stromführenden Leitern 5, 6, 7 gebildet. In den Messspulen 8, 9, 10, 11 werden bei Stromänderungen Spannungen erzeugt, wobei die Spannungen in der Auswerteschaltung 12 zur Bestimmung der Stromanstiege in den stromführenden Leitern 5, 6, 7 heranziehbar sind.

Der Vollständigkeit wird an Hand der Fig. 1 und 2 auch eine Erfassung des Stromanstieges für einen Leiter 5 dargelegt. Bei einer Schaltungsanordnung zur Erfassung von mindestens einem Stromanstieg in nur einem auf einer Leiterplatte angeordneten Leiter 5 ist der einfache magnetische Kreis 1 vorgesehen, der den zu messenden elektrischen Leiter 5 einschließt. Der magnetische Kreis 1 nutzt die Leiterplatte als Spalt 4. Mindestens eine, vorzugsweise eine geprintet ausgeführte, Messspule 8, gegebenenfalls mit einem Layerwechsel wegen der Kreuzung, ist im Bereich des magnetischen Kreises 1 angeordnet. Die Messspule 8 erfasst gemeinsam mit der Messspule 9 den Flussanstieg des zu messenden Stromanstieges unter Verwendung des bekannten Durchflutungssatzes im Leiter 5 als Spulenspannung und ist mit der messtechnischen Auswerteschaltung 12 verbunden.

Generell kann im Bereich des Magnetfeldes des einfachen magnetischen Kreises 1 mindestens ein magnetfeldsensitives Bauelement, vorzugsweise als Hall-Element realisiert, vorgesehen sein, das eine stromproportionale Größe als Ausgangsgröße der Auswerteschaltung 12 zur Verfügung stellt.

Der einfache magnetische Kreis 1 wird unter Verwendung von magnetisch leitfähigen, vorzugsweise geometrisch einfach geformten, Elementen gebildet. Die magnetisch leitfähigen Elemente weisen beispielsweise die Form dünner Quader auf, die an der Ober- und Unterseite der Leiterplatte, vorzugsweise senkrecht auf den zu messenden stromführenden Leiter 5, 6, 7 angeordnet sind. Die, feste oder flexible, Leiterplatte bildet den definierten Spalt 2 im magnetischen Kreis 1 und im bzw. am Spalt 4 ist mindestens eine Messspule 8, 9, 10 vorgesehen, die auf mindestens einem Layer der Leiterplatte realisiert ist. Wie ja an sich bekannt, kann die Leiterplatte aus mehreren Layern bestehen.

Nachstehend wird ein Beispiel einer Einzelleiter-Stromanstiegsmessung erklärt: Wird der Stromanstieg eines einzelnen Leiters 5 erfasst, so kann links und rechts neben dem Leiter eine gleichartige Messspule 8, 9 vorzugsweise geprintet, ein- oder mehrlagig, ausgeführt werden. Über diese beiden Messspulen 8, 9 wird nun an Ober- und Unterseite je ein magnetisch leitfähiger, vorzugsweise wirbelstrom-unterdrückender Streifen, beispielsweise aus Ferrit, aufgebracht. Die Dicke des Streifens ist vorzugsweise so zu wählen, dass bei größter auftretender Stromstärke die Flussdichte im Streifen unterhalb der Sättigungsflussdichte bleibt. Dies kann aus dem bekannten Durchflutungssatz, angewendet auf den magnetischen Kreis 1, unter Voraussetzung eines bekannten Spalts 4, berechnet werden. Beide Messspulen 8, 9 messen daher aufgrund des Stromanstiegs des eingeschlossenen Leiters 5 zwei gegengleiche Spannungswerte, die in der Auswerteschaltung 12 oder einfach durch Antiserienschaltung der beiden Messspulen 8, 9 betragsmäßig zusammengezählt werden. Ein allfälliges Fremdfeld erzeugt in beiden Messspulen 8, 9 praktisch gleiche Spannungen und wird durch die Antiserienschaltung bzw. Subtraktion der Signale messtechnisch kompensiert und stört das Messergebnis nicht. Falls störende Fremdfelder ausgeschlossen werden können, genügt im Prinzip nur eine einzige Messspule 8. Ergänzend dazu wird ein Beispiel für eine Dreileiter-Stromanstiegsmessung erklärt:
Als Beispiel zur Erfassung von mehr als einem Stromanstieg wird ein auf der Leiterplatte geprintetes Dreileiter-Drehstromsystem betrachtet. Die drei Leiter 5, 6, 7 seien in einem Abstand voneinander entfernt angeordnet, so dass innerhalb des Abstandes eine Messspule 8, 9, 10, 11 wie erwähnt angeordnet werden kann. Weiters sind sie im Bereich der Stromanstiegserfassung geometrisch vorzugsweise parallel ausgeführt. Es sind insgesamt vier Messspulen möglich: Je eine links und rechts des Leitersystems sowie zwei zwischen den drei Leitern 5, 6, 7. Damit können vier Messungen zur Bestimmung von drei Stromanstiegen sowie des Fremdfeldes durchgeführt werden. Für den Sonderfall, dass die Summe der drei Ströme, und damit auch der drei Stromanstiege, Null ist, beispielsweise die drei Leiter 5, 6, 7 sind an die drei Klemmen einer in Stern oder Dreieck geschalteten Drehstrommaschine 13 angeklemmt, ist eine Information redundant. Die zwischen den zwei äußeren Messspulen 8, 11 eingeschlossenen Durchflutungen sind dann Null. Können auch Fremdfelder vernachlässigt werden, genügen sogar zwei Messspulen. Natürlich kann die redundante Information zur gegenseitigen Überprüfung der Messungen, zum Erkennen eines Kurzschlusses gegenüber Gehäuse ähnlich einem Fehlerstromschutzschalter bzw. zum Aufbau von sicheren Systemen verwendet werden.

Die zur Bestimmung der Stromanstiege in den stromführenden Leitern 5, 6, 7 verwendeten Spannungen werden in weiterer Folge in der übergeordneten Steuerung 14 zu höheren Aufgaben, wie etwa Positionsbestimmung, Strom- und Drehzahlregelung und ähnliche herangezogen. Optionale weitere Messungen, wie etwa Spannungsmessungen 15 können zur genaueren Bestimmung des Zustandes des elektromagnetischen Systems, vorzugsweise der Drehstrommaschine 13, der Auswerteschaltung 12 zugeführt werden.

Weiters kann der Stromanstieg unter Verwendung der mathematischen Beschreibung des angeschlossenen elektromagnetischen Systems zur Bestimmung des Stromes verwendet werden. Ferner kann neben einer Messung des Stromanstiegs mindestens eine weitere elektrische Größe, vorzugsweise mindestens eine Spannung des Systems "Umrichter - elektromagnetischer Wandler", erfasst werden. Bei der Auswertung der Messspulen 8, 9, 10, 11 können die magnetischen Fremdfelder in der Auswertung auf mathematischem Wege eliminiert werden.

Die über die Messspulen 8, 9, 10, 11 erfassten Stromanstiege können zusätzlich zu Strommessungen zwecks Erfassung einer von den Strommessungen unabhängigen zweiten Informationsquelle über den aktuellen Stromzustand im Sinne einer Strommessungsüberwachung verwendet werden.

Ein gravierender Vorteil ist, dass die ermittelten Stromanstiege für ein Verfahren zur sensorlosen Drehwinkelerfassung einer über einen Stromrichter gespeisten synchron mit dem Drehfeld laufenden Maschine (gemäß dem INFORM^{®}-Verfahren) zur Bestimmung der Rotor- bzw. Rotorflussposition von Drehstrommaschinen herangezogen werden können. Darüber hinaus können die ermittelten Stromanstiege gemäß dem auf Magnetlager angepassten Verfahren zur sensorlosen Drehwinkelerfassung einer über einen Stromrichter gespeisten synchron mit dem Drehfeld laufenden Maschine (lNFORM^{®}-Verfahren) zur Bestimmung von Positionsabweichungen des bewegten Teiles eines Magnetlagers gegenüber Referenzpositionen, vorzugsweise in mindestens zwei Raumrichtungen, herangezogen werden.

Durch Parallel- bzw. Antiparallelführung mindestens zweier stromführender Leiterbahnen innerhalb des einfachen magnetischen Kreises 1 kann eine magnetische Addition bzw. Subtraktion der beiden Durchflutungen durchgeführt werden und dadurch wird in den Messspulen 8, 9, 10, 11 aufgrund der Summation bzw. Subtraktion der entsprechenden Teilfelder eine direkte Summation bzw. Subtraktion der beteiligten Stromanstiege erreicht. So ist es möglich, dass die Messspulen 8, 9, 10, 11 ein Signal zur Fehlerstromüberwachung, vorzugsweise Erdschlussüberwachung, liefern.

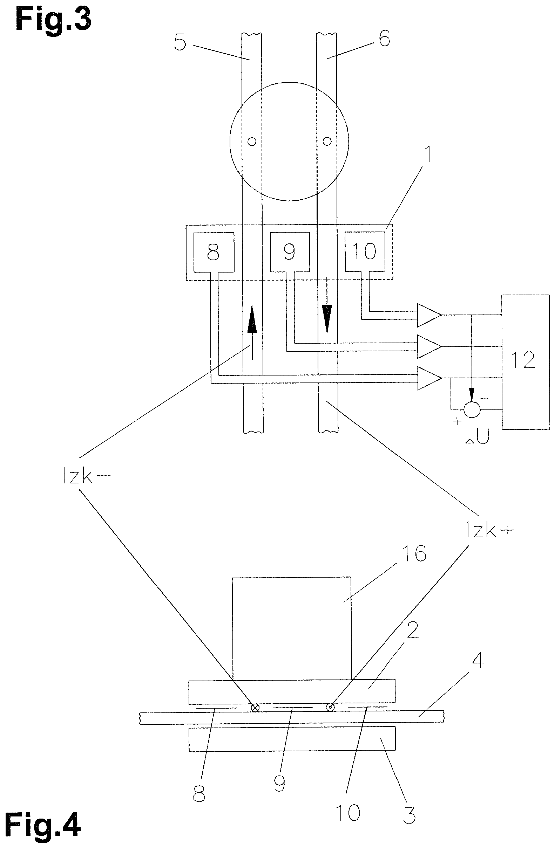

Gemäß der Fig. 3 und Fig. 4 wird die Erfassung eines Stromanstieges von zwei Strom führenden Leitern eines Zwischenkreises dargelegt. Der Aufbau entspricht prinzipiell dem Aufbau der Schaltungsanordnung gemäß den Fig. 1 und Fig. 2. Die zwei Strom (Izk+ und Izk-)- führenden Leiter 5, 6 des Zwischenkreises, der durch die Zwischenkreiskapazität 16 (Czk) gestützt wird, sind innerhalb des einfachen magnetischen Kreises 1 im Leiterplattenspalt 4 mit den Messspulen 8,10 derart geführt, dass die beiden Durchflutungen (Izk+ und Izk-) subtrahiert werden und somit in den Messspulen 8, 10 zwei gegengleiche Spannungen induziert werden, die sich nur durch allfällige externe Störfeldänderungen unterscheiden, welche bei Differenzbildung der Spannungen der Messspulen 8, 10 störfeldbefreit sind und daher die Differenz im Regulär-Betrieb ΔU = 0 Volt ist und dadurch bei merkbarer Abweichung der Spannung ΔU von Null eine Fehlerstrom- bzw. Erdschlusserkennung realisiert wird.

## Patentansprüche

1. Schaltungsanordnung zur Erfassung von n Stromanstiegen in n auf einer Leiterplatte angeordneten geprinteten Leitern, wobei n ≥ 2 und wobei ein magnetischer Kreis (1), unter Verwendung von magnetisch leitfähigen, geometrisch geformten, Elementen, vorgesehen ist, der die zu messenden elektrischen geprinteten Leiter (5, 6, 7) einschließt, wobei der magnetische Kreis (1) die Leiterplatte als Spalt (4) nutzt und wobei n+1, aus mindestens einem Layer geprintet ausgeführte, Messspulen (8, 9, 10, 11) im Bereich des magnetischen Kreises (1) angeordnet sind, wobei die Messspulen (8, 9, 10, 11) die Flussanstiege der zu messenden Stromanstiege in den geprinteten Leitern (5, 6, 7) als Spulenspannungen erfassen und wobei eine messtechnische Auswerteschaltung (12) vorgesehen ist, die mit den Messspulen (8, 9, 10, 11) verbunden ist, wobei über die Messspulen (8, 9,10,11) an einer Ober- und Unterseite je ein magnetisch leitfähiger, wirbelstrom-unterdrückender Streifen bzw. Element, beispielsweise aus Ferrit, angeordnet ist, wobei die Dicke des Streifens so zu wählen ist, dass bei größter auftretender Stromstärke die Flussdichte im Streifen unterhalb der Sättigungsflussdichte bleibt, wobei die geprinteten Leiter (5,6,7) in einen Abstand voneinander entfernt angeordnet sind, sodass zwischen den Leitern und links und rechts der Leiter jeweils eine Messspule (8,9,10,11) zum Erfassen von insgesamt n+1 Messungen zur Bestimmung von n Stromanstiegen sowie auch eines Fremdfeldes angeordnet sind.

2. Schaltungsanordnung nach Anspruch 1, **dadurch gekennzeichnet, dass** die magnetisch leitfähigen Elemente beispielsweise die Form dünner Quader aufweisen, die an der Ober- und Unterseite der Leiterplatte, vorzugsweise senkrecht auf die zu messenden stromführenden Leiter (5, 6, 7), angeordnet sind und die, feste oder flexible, Leiterplatte den definierten Spalt (4) im magnetischen Kreis (1) bildet und dass im bzw. am Spalt (4) n+1 Messspulen (8, 9, 10, 11), realisiert auf mindestens einem Layer der Leiterplatte, vorgesehen sind.

3. Schaltungsanordnung nach Anspruch 1 oder 2, **dadurch gekennzeichnet, dass** der einfache magnetische Kreis (1) bei einem dreisträngigen Stromsystem aus magnetisch leitfähigen Elementen gemeinsam mit dem Spalt (4) der Leiterplatte und den zu messenden stromführenden Leitern (5, 6, 7) gebildet ist, der in den Messspulen (8, 9, 10, 11) bei Stromänderungen Spannungen erzeugt, wobei die Spannungen in der Auswerteschaltung (12) zur Bestimmung der Stromanstiege in den stromführenden Leitern (5, 6, 7) heranziehbar sind.

4. Schaltungsanordnung nach einem oder mehreren der Ansprüche 1 bis 3, **dadurch gekennzeichnet, dass** im Bereich des Magnetfeldes des einfachen magnetischen Kreises (1) mindestens ein magnetfeldsensitives Bauelement, vorzugsweise als Hall-Element realisiert, vorgesehen ist, das eine stromproportionale Größe als Ausgangsgröße der Auswerteschaltung (12) zur Verfügung stellt.

5. Verfahren zur Erfassung von n Stromanstiegen in n auf einer Leiterplatte angeordneten geprinteten Leitern nach einem oder mehreren der Ansprüche 1 bis 4, wobei der magnetische Kreis (1) bei Stromänderungen in den geprinteten Leitern (5, 6, 7) Spannungen in den Messspulen (8, 9, 10, 11) erzeugt, die in einer Auswerteschaltung (12) zur Bestimmung der Stromanstiege in den stromführenden geprinteten Leitern (5, 6, 7) verwendet werden, wobei über den Messspulen (8, 9,10,11) an einer Ober- und Unterseite je ein magnetisch leitfähiger, wirbelstrom-unterdrückender Streifen bzw. Element, beispielsweise aus Ferrit, aufgebracht werden, wobei die Dicke des Streifens so zu wählen ist, dass bei größter auftretender Stromstärke die Flussdichte im Streifen unterhalb der Sättigungsflussdichte bleibt, wobei die geprinteten Leiter (5,6,7) in einen Abstand voneinander entfernt angeordnet werden, wobei zwischen den Leitern und links und rechts der Leiter jeweils eine Messspule (8,9,10,11) angeordnet wird, über die insgesamt n+1 Messungen zur Bestimmung von n Stromanstiegen sowie eines Fremdfeldes durchgeführt werden.

6. Verfahren nach Anspruch 5, **dadurch gekennzeichnet, dass** die n Stromanstiege unter Verwendung der mathematischen Beschreibung des angeschlossenen elektromagnetischen Systems zur Bestimmung des Stromes verwendet wird.

7. Verfahren nach Anspruch 5 oder 6, **dadurch gekennzeichnet, dass** neben den Messungen der Stromanstiege mindestens eine weitere elektrische Größe, vorzugsweise mindestens eine Spannung des Systems "Umrichter - elektromagnetischer Wandler", erfasst wird.

8. Verfahren nach mindestens einem der Ansprüche 5 bis 7, **dadurch gekennzeichnet, dass** bei der Auswertung der Messspulen die magnetischen Fremdfelder in der Auswertung auf mathematischem Wege eliminiert werden.

9. Verfahren nach mindestens einem der Ansprüche 5 bis 8, **dadurch gekennzeichnet, dass** die über die Messspulen (8, 9, 10, 11) erfassten Stromanstiege zusätzlich zu Strommessungen zwecks Erfassung einer von den Strommessungen unabhängigen zweiten Informationsquelle über den aktuellen Stromzustand im Sinne einer Strommessungsüberwachung verwendet werden.

10. Verfahren nach mindestens einem der Ansprüche 5 bis 9, **dadurch gekennzeichnet, dass** die ermittelten Stromanstiege für ein Verfahren zur sensorlosen Drehwinkelerfassung einer über einen Stromrichter gespeisten synchron mit dem Drehfeld laufenden Maschine (gemäß dem INFORM^{®}-Verfahren) zur Bestimmung der Rotor- bzw. Rotorflussposition von Drehstrommaschinen (13) herangezogen werden.

11. Verfahren nach mindestens einem der Ansprüche 5 bis 10, **dadurch gekennzeichnet, dass** die ermittelten Stromanstiege gemäß dem auf Magnetlager angepassten Verfahren zur sensorlosen Drehwinkelerfassung einer über einen Stromrichter gespeisten synchron mit dem Drehfeld laufenden Maschine (INFORM^{®}-Verfahren) zur Bestimmung von Positionsabweichungen des bewegten Teiles eines Magnetlagers gegenüber Referenzpositionen, vorzugsweise in mindestens zwei Raumrichtungen, herangezogen werden.

12. Verfahren nach mindestens einem der Ansprüche 5 bis 11, **dadurch gekennzeichnet, dass** durch Parallel- bzw. Antiparallelführung mindestens zweier stromführender Leiterbahnen innerhalb des einfachen magnetischen Kreises (1) eine magnetische Addition bzw. Subtraktion der eingeschlossenen Durchflutungen durchgeführt wird und dadurch in den Messspulen (8, 9, 10, 11) aufgrund der Summation bzw. Subtraktion der entsprechenden Teilfelder eine direkte Summation bzw. Subtraktion der beteiligten Stromanstiege erreicht wird.

13. Verfahren nach Anspruch 12, **dadurch gekennzeichnet, dass** die Messspulen (8, 9, 10, 11) ein Signal zur Fehlerstromüberwachung, vorzugsweise Erdschlussüberwachung, liefern.

14. Verfahren nach mindestens einem der Ansprüche 5 bis 13, **dadurch gekennzeichnet, dass** die zur Bestimmung der Stromanstiege in den stromführenden Leitern (5, 6, 7) verwendeten Spannungen in weiterer Folge in der übergeordneten Steuerung (14) zu höheren Aufgaben, wie etwa Positionsbestimmung, Strom- und Drehzahlregelung und ähnliche herangezogen werden, wobei optionale weitere Messungen, wie etwa Spannungsmessungen (15) zur genaueren Bestimmung des Zustandes des elektromagnetischen Systems, vorzugsweise einer elektrischen Maschine, der Auswerteschaltung (12) zugeführt werden.

15. Verfahren nach mindestens einem der Ansprüche 5 bis 14, **dadurch gekennzeichnet, dass** die zwei Strom (Izk+ und Izk-)- führenden Leiter des Zwischenkreises eines Umrichters, der gegebenenfalls durch die Zwischenkreiskapazität Czk (16) oder einer Drossel gestützt wird, innerhalb des einfachen magnetischen Kreises (1) im Spalt (4) mit den Messspulen (8, 10) derart geführt sind, dass die beiden Durchflutungen (Izk+ und Izk-) subtrahiert werden und somit in den Messspulen (8, 10) zwei gegengleiche Spannungen induziert werden, die sich nur durch allfällige externe Störfeldänderungen unterscheiden, welche bei Differenzbildung der Spannungen der Messspulen (8, 10) störfeldbefreit sind und daher die Differenz im Regulärbetrieb ΔU = 0 Volt ist und dadurch bei merkbarer Abweichung der Spannung ΔU von Null eine Fehlerstrom- bzw. Erdschlusserkennung realisiert wird.

## Claims

1. Circuit arrangement for detecting n current rises in n printed conductors (5, 6, 7) arranged on a printed circuit board, where n ≥ 2 and where a magnetic circuit (1) is provided, using magnetically conductive, geometrically shaped elements, which encloses the printed electrical conductors (5, 6, 7) to be measured, where the magnetic circuit (1) uses the printed circuit board as a gap (4) and where n+1 measuring coils (8, 9, 10, 11) printed from at least one layer are arranged in the area of the magnetic circuit (1), whereby the measuring coils (8, 9, 10, 11) detect the flux increases of the current increases to be measured in the printed conductors (5, 6, 7) as coil voltages, and whereby a metrological evaluation circuit (12) is provided, connected to the measuring coils (8, 9, 10, 11), wherein a magnetically conductive, eddy-current-suppressing strip or element, respectively, for example made of ferrite, is arranged over each of the measuring coils (8, 9,10,11) on an upper and lower side, wherein in each case the thickness of the strip is to be selected in such a way that at the highest amperage occurring the flux density in the strip remains below the saturation flux density, whereby the printed conductors (5, 6, 7) are arranged at a distance from one another, so that a measuring coil (8, 9, 10, 11) is arranged between each pair of conductors (5, 6, 7) and to the left and right of the conductors (5, 6, 7), for recording a total of n+1 measurements for determining n current rises as well as an external field.

2. Circuit arrangement according to Claim 1, **characterized in that** the magnetically conductive elements have, for example, the form of thin cuboids which are arranged on the upper and lower side of the printed circuit board, preferably in perpendicular orientation to the current-carrying conductors (5, 6, 7) to be measured, and the fixed or flexible printed circuit board forms the defined gap (4) in the magnetic circuit (1), and **in that** n+1 measuring coils (8, 9, 10, 11), realized on at least one layer of the printed circuit board, are provided in or at the gap (4), respectively.

3. Circuit arrangement according to Claim 1 or 2, **characterized in that** the simple magnetic circuit (1) is formed in a three-phase current system from magnetically conductive elements together with the gap (4) of the printed circuit board and the current-carrying conductors (5, 6, 7) to be measured, which generates voltages in the measuring coils (8, 9, 10, 11) in the event of current changes, whereby it is possible to use the voltages in the evaluation circuit (12) to determine the current increases in the current-carrying conductors (5, 6, 7).

4. Circuit arrangement according to one or several of Claims 1 to 3, **characterized in that** at least one magnetic field-sensitive component, preferably implemented as a Hall element, is provided in the area of the magnetic field of the simple magnetic circuit (1) and makes a current-proportional variable available as an output variable of the evaluation circuit (12).

5. Method for detecting n current increases in n printed conductors (5, 6, 7) arranged on a printed circuit board according to one or several of Claims 1 to 4, whereby in case of current changes in the printed conductors (5, 6, 7) the magnetic circuit (1) generates voltages in the measuring coils (8, 9, 10, 11), which changes are used in an evaluation circuit (12) to determine the current increases in the current-carrying printed conductors (5, 6, 7), whereby a magnetically conductive, eddy-current-suppressing strip or element, respectively, for example made of ferrite, is applied over each of the measuring coils (8, 9,10,11) on an upper and lower side, wherein in each case the thickness of the strip is to be selected in such a way that at the highest amperage occurring the flux density in the strip remains below the saturation flux density, whereby the printed conductors (5, 6, 7) are arranged at a distance from one another, wherein a measuring coil (8, 9, 10,11) is arranged between each pair of conductors (5, 6, 7) and to the left and right of the conductors (5, 6, 7), via which measuring coils a total of n+1 measurements are carried out to determine n current rises as well as an external field.

6. The method according to Claim 5, **characterized in that** the n current increases are used to determine the current using the mathematical description of the connected electromagnetic system.

7. Method according to Claim 5 or 6, **characterized in that**, in addition to the measurements of the current increases, at least one further electrical variable, preferably at least one voltage of the "converter - electromagnetic converter" system, is recorded.

8. Method according to at least one of Claims 5 to 7, **characterized in that** during the evaluation of the measuring coils the magnetic external fields are eliminated in the evaluation by mathematical means.

9. Method according to at least one of Claims 5 to 8, **characterized in that** the current increases detected via the measuring coils (8, 9, 10, 11) are used in addition to current measurements for the purpose of recording a second source of information, independent of the current measurements, about the latest current state in terms of current measurement monitoring.

10. Method according to at least one of Claims 5 to 9, **characterized in that** the current increases determined are used for a method for sensorless rotational angle detection of a machine fed via a converter and running synchronously with the rotating field (according to the INFORM^{®} method) for determining the rotor or rotor flux position, respectively, of three-phase machines (13).

11. Method according to at least one of Claims 5 to 10, **characterized in that** the current increases determined are used in accordance with the method adapted to magnetic bearings for sensorless detection of the angle of rotation of a machine fed via a converter and running synchronously with the rotating field (INFORM^{®} method) to determine position deviations of the moving part of a magnetic bearing relative to reference positions, preferably in at least two spatial directions.

12. Method according to at least one of Claims 5 to 11, **characterized in that** by parallel or anti-parallel routing of at least two current-carrying conductor tracks within the simple magnetic circuit (1), a magnetic addition or subtraction of the enclosed fluxes is carried out and thereby in the measuring coils (8, 9, 10, 11), on the basis of the summation or subtraction, respectively, of the corresponding partial fields, a direct summation or subtraction of the involved current increases is achieved.

13. Method according to Claim 12, **characterized in that** the measuring coils (8, 9, 10, 11) provide a signal for fault current monitoring, preferably ground fault monitoring.

14. Method according to at least one of Claims 5 to 13, **characterized in that** the voltages used for determining the current increases in the current-carrying conductors (5, 6, 7) are subsequently used in the higher-level controller (14) for higher-level tasks, such as position determination, current and speed control and the like, whereby optional further measurements, such as voltage measurements (15) are fed to the evaluation circuit (12) for more precise determination of the state of the electromagnetic system, preferably of an electrical machine.

15. Method according to at least one of the Claims 5 to 14, **characterized in that** the two current (Izk+ and Izk-)-carrying conductors of the intermediate circuit of a converter, which is possibly supported by the intermediate circuit capacitance Czk (16) or a choke, are guided within the simple magnetic circuit (1) in the gap (4) with the measuring coils (8, 10) in such a way that the two fluxes (Izk+ and Izk-) are subtracted and thus two opposite voltages are induced in the measuring coils (8, 10), which differ only by possible external interference field changes, which are free of interference fields when the voltages of the measuring coils (8, 10) are differentiated and therefore the difference in regular operation is ΔU = 0 volts and thus in the case of a noticeable deviation of the voltage ΔU from zero a fault current or ground fault detection, respectively, is realized.

## Revendications

1. Circuit pour la détection de n montées de courant dans n circuits imprimés (5, 6, 7) disposés sur une carte de circuits imprimés, où n ≥ 2 et où un circuit magnétique (1) est prévu en utilisant des éléments conducteurs magnétiques, de forme géométrique, qui renferme les circuits électriques imprimés (5, 6, 7) à mesurer, le circuit magnétique (1) utilisant la carte de circuits imprimés comme entrefer (4) et où n+1 bobines de mesure (8, 9, 10, 11), composées d'au moins une couche de circuits imprimés, sont disposées dans la zone du circuit magnétique (1), les bobines de mesure (8, 9, 10, 11) détectant les augmentations de flux des montées de courant à mesurer dans les circuits imprimés (5, 6, 7) sous forme de tensions de bobine, et un circuit d'évaluation (12) de mesure étant prévu, qui est relié aux bobines de mesure (8, 9, 10, 11), une bande ou un élément magnétiquement conducteur, par exemple en ferrite, supprimant les courants de Foucault, étant respectivement disposé au-dessus des bobines de mesure (8, 9, 10, 11) sur une face supérieure et une face inférieure, l'épaisseur de la bande devant être choisie de manière à ce que la densité de flux dans la bande reste inférieure à la densité de flux de saturation en présence de l'intensité maximale du courant, les circuits imprimés (5, 6, 7) étant disposés à une certaine distance les uns des autres, de sorte qu'une bobine de mesure (8, 9, 10, 11) est respectivement disposée entre les circuits (5, 6, 7) et à gauche et à droite des circuits (5, 6, 7) pour détecter, au total, n+1 mesures pour déterminer n montées de courant ainsi qu'un champ étranger.

2. Circuit selon la revendication 1, **caractérisé en ce que** les éléments magnétiquement conducteurs ont par exemple la forme de parallélépipèdes fins, qui sont disposés sur la face supérieure et la face inférieure de la carte de circuits imprimés, de préférence perpendiculairement aux circuits conducteurs de courant (5, 6, 7) à mesurer, et la carte de circuits imprimés, rigide ou flexible, forme l'entrefer (4) défini dans le circuit magnétique (1), et **en ce que** n+1 bobines de mesure (8, 9, 10, 11) sont prévues dans ou sur l'entrefer (4), réalisées sur au moins une couche de la carte de circuits imprimés.

3. Circuit selon la revendication 1 ou 2, **caractérisé en ce que** le circuit magnétique simple (1), dans le cas d'un système de courant à trois branches, est constitué d'éléments magnétiquement conducteurs conjointement avec l'entrefer (4) de la carte de circuits imprimés et des circuits conducteurs de courant (5, 6, 7) à mesurer, qui génère des tensions dans les bobines de mesure (8, 9, 10, 11) en cas de variations de courant, les tensions pouvant être utilisées dans le circuit d'évaluation (12) pour déterminer les montées de courant dans les circuits conducteurs de courant (5, 6, 7).

4. Circuit selon une ou plusieurs des revendications 1 à 3, **caractérisé en ce qu'**au moins un élément de construction sensible au champ magnétique, réalisé de préférence sous la forme d'un élément de Hall, est prévu dans la zone du champ magnétique du circuit magnétique simple (1), qui met à disposition une grandeur proportionnelle au courant en tant que grandeur de sortie du circuit d'évaluation (12).

5. Procédé de détection de n montées de courant dans n circuits imprimés (5, 6, 7) disposés sur une carte de circuits imprimés selon une ou plusieurs des revendications 1 à 4, le circuit magnétique (1) générant, en cas de variations de courant dans les circuits imprimés (5, 6, 7), des tensions dans les bobines de mesure (8, 9, 10, 11), qui sont utilisées dans un circuit d'évaluation (12) pour déterminer les montées de courant dans les circuits imprimés conducteurs de courant (5, 6, 7), une bande ou un élément magnétiquement conducteur, par exemple en ferrite, supprimant les courants de Foucault, étant respectivement disposé au-dessus des bobines de mesure (8, 9, 10, 11) sur une face supérieure et une face inférieure, l'épaisseur de la bande devant être choisie de manière à ce que la densité de flux dans la bande reste inférieure à la densité de flux de saturation en présence de l'intensité maximale du courant, les circuits imprimés (5, 6, 7) étant disposés à une certaine distance les uns des autres, de sorte qu'une bobine de mesure (8, 9, 10, 11) est respectivement disposée entre les circuits (5, 6, 7) et à gauche et à droite des circuits (5, 6, 7), par le biais de laquelle sont effectuées, au total, n+1 mesures pour déterminer n montées de courant ainsi qu'un champ étranger.

6. Procédé selon la revendication 5, **caractérisé en ce que** les n montées de courant sont employées en utilisant la description mathématique du système électromagnétique raccordé pour déterminer le courant.

7. Procédé selon la revendication 5 ou 6, **caractérisé en ce que**, en plus des mesures des montées de courant, au moins une autre grandeur électrique, de préférence au moins une tension du système "onduleur - transducteur électromagnétique", est détectée.

8. Procédé selon au moins l'une des revendications 5 à 7, **caractérisé en ce que**, lors de l'évaluation des bobines de mesure, les champs magnétiques étrangers sont éliminés par voie mathématique dans l'évaluation.

9. Procédé selon au moins l'une des revendications 5 à 8, **caractérisé en ce que** les montées de courant détectées par le biais les bobines de mesure (8, 9, 10, 11) sont utilisées, en plus des mesures de courant, en vue de la détection d'une deuxième source d'information sur l'état actuel du courant, indépendante des mesures de courant, au sens d'une surveillance des mesures de courant.

10. Procédé selon au moins l'une des revendications 5 à 9, **caractérisé en ce que** les montées de courant déterminées sont employées pour un procédé de détection sans capteur de l'angle de rotation d'une machine alimentée par un convertisseur de courant et fonctionnant de manière synchrone avec le champ tournant (selon le procédé INFORM^{®}) pour déterminer la position du rotor ou du flux rotorique de machines (13) à courant triphasé.

11. Procédé selon au moins l'une des revendications 5 à 10, **caractérisé en ce que** les montées de courant déterminées sont employées, conformément au procédé adapté aux paliers magnétiques pour la détection sans capteur de l'angle de rotation d'une machine alimentée par un convertisseur de courant et fonctionnant de manière synchrone avec le champ tournant (procédé INFORM^{®}) pour déterminer des écarts de position de la partie mobile d'un palier magnétique par rapport à des positions de référence, de préférence dans au moins deux directions dans l'espace.

12. Procédé selon au moins l'une des revendications 5 à 11, **caractérisé en ce qu'**une addition ou soustraction magnétique des courants totalisés inclus est effectuée par guidage parallèle ou antiparallèle d'au moins deux pistes conductrices de courant à l'intérieur du circuit magnétique simple (1), et qu'il est ainsi possible d'obtenir, dans les bobines de mesure (8, 9, 10, 11), une totalisation ou une soustraction directe des montées de courant impliquées en raison de la totalisation ou de la soustraction des champs partiels correspondants.

13. Procédé selon la revendication 12, **caractérisé en ce que** les bobines de mesure (8, 9, 10, 11) fournissent un signal pour la surveillance du courant différentiel résiduel, de préférence la surveillance du défaut à la terre.

14. Procédé selon au moins l'une des revendications 5 à 13, **caractérisé en ce que** les tensions utilisées pour déterminer les montées de courant dans les circuits conducteurs de courant (5, 6, 7) sont utilisées par la suite dans la commande (14) de niveau hiérarchiquement supérieur pour des tâches plus élevées, telles que la détermination de la position, la régulation du courant et de la vitesse de rotation et similaires, d'autres mesures optionnelles, telles que des mesures de tension (15), étant fournies au circuit d'évaluation (12) pour déterminer plus précisément l'état du système électromagnétique, de préférence d'une machine électrique.

15. Procédé selon au moins l'une des revendications 5 à 14, **caractérisé en ce que** les deux conducteurs de courant (Izk+ et Izk-)- du circuit intermédiaire d'un onduleur, qui est éventuellement soutenu par la capacité de circuit intermédiaire Czk (16) ou celle d'une bobine d'inductance, sont acheminés, à l'intérieur du circuit magnétique simple (1), dans l'entrefer (4) avec les bobines de mesure (8, 10) de telle sorte que les deux courants totalisés (Izk+ et Izk-) sont soustraits et que deux tensions diamétralement opposées sont ainsi induites dans les bobines de mesure (8, 10), qui ne se distinguent que par d'éventuelles modifications externes du champ perturbateur, lesquelles sont exemptes de champ perturbateur lors de la formation de la différence des tensions des bobines de mesure (8, 10) et que, par conséquent, la différence en fonctionnement régulier est ΔU = 0 volt et que, en cas d'écart perceptible de la tension ΔU par rapport à zéro, une détection du courant différentiel résiduel ou du défaut à la terre est ainsi réalisée.
